# EUROPEAN PATENT APPLICATION

(11) **EP 4 376 565 A1**
(43) Date of publication of application: **29.05.2024**
(21) Application number: 22856177.5
(22) Date of filing: 09.08.2022
(51) Int. Cl.: H05K 7/20, H05K 1/11, H05K 3/46

(54) **CIRCUIT BOARD MODULE AND METHOD FOR MANUFACTURING SAME**

(30) Priority: 10.08.2021 KR 20210105202
(71) Applicant: Samsung Electronics Co., Ltd., Suwon-si, Gyeonggi-do 16677 (KR)
(72) Inventor: CHO, Yonglak, Suwon-si Gyeonggi-do 16677 (KR); KIM, Joohan, Suwon-si Gyeonggi-do 16677 (KR); KIM, Juho, Suwon-si Gyeonggi-do 16677 (KR); PARK, Min, Suwon-si Gyeonggi-do 16677 (KR); PARK, Eunsoo, Suwon-si Gyeonggi-do 16677 (KR); AN, Insun, Suwon-si Gyeonggi-do 16677 (KR); LEE, Byungwoo, Suwon-si Gyeonggi-do 16677 (KR); LEE, Sangtae, Suwon-si Gyeonggi-do 16677 (KR); LEE, Haejin, Suwon-si Gyeonggi-do 16677 (KR)
(74) Representative: Appleyard Lees IP LLP
(86) International application number: PCT/KR2022/011858
(87) International publication number: WO 2023/018180

(57) **Abstract**

A circuit board module according to various embodiments of the present disclosure may comprise: a first substrate; a second substrate including a first opening and disposed over the first substrate; an interposer disposed between the first substrate and the second substrate to connect the first substrate and the second substrate and providing a first space between the first substrate and the second substrate; a sealing member attached to cover the first opening; and a filler disposed between the first substrate and the second substrate, wherein the sealing member includes an insertion area in which a filler insertion nozzle is inserted into the first opening, and a second opening through which air is introduced into the first space and a third opening through which air is discharged from the first space are formed through at least one of the first substrate, the second substrate, and the interposer.

## Description

### [Technical Field]

Various embodiments of the disclosure relate to a circuit board module, an electronic device including the circuit board module, and a method of manufacturing the same.

### [Background Art]

Thanks to remarkable advances in information and communication technology and semiconductor technology, the spread and use of various electronic devices have been increasing rapidly. In particular, recent electronic devices have been developed to be portable and enable communication.

An electronic device may refer to any device that performs a specific function according to a program installed on it, such as a consumer electronics device, an electronic notebook, a portable multimedia player, a mobile communication terminal, a tablet PC, an audio/video device, a desktop/laptop computer, or an in-vehicle navigation system. For example, these electronic devices may output stored and/or transmitted information as sound or an image. In recent years, as the integration level of electronic devices has increased and high-speed, large-capacity wireless communication has become more common, a single electronic device, such as a mobile communication terminal, may be equipped with a variety of functions. For example, in addition to a communication function, an entertainment function such as games, a multimedia function such as music and video playback, a communication and security function such as mobile banking, and a function such as schedule management and an electronic wallet are integrated into a single electronic device. These electronic devices are being miniaturized so that they may be conveniently carried by users.

A printed circuit board disposed within an electronic device may be manufactured as a stacked type (e.g., a circuit board module), for mounting efficiency. Circuit boards located within the stacked printed circuit board may be designed to be side by side with corresponding sizes. In this structure, many empty spaces exist according to various thicknesses of components mounted therein.

### [Detailed Description of the Invention]

### [Technical Problem]

There may be various heat sources (e.g., an application processor) on a printed circuit board. In such an environment, it may be necessary to apply a filler to the interior of a stacked printed circuit board, for dissipation of heat generated by heat sources. In applying the filler to the interior of the printed circuit board, the viscosity of the filler or the thermal expansion of air inside the printed circuit board may cause the filler to flow back or out.

According to various embodiments of the disclosure, a printed circuit board may be provided, which includes a sealing member sealing a filler inlet. Accordingly, even when a high-viscosity filler is injected into the printed circuit board at a high speed, backflow of the filler may be prevented.

According to various embodiments of the disclosure, a plurality of openings for controlling an air flow inside a printed circuit board may be provided. Accordingly, a filler may be applied stably even when a high temperature environment is created inside the printed circuit board.

### [Technical Solution]

According to various embodiments, a circuit board module inside an electronic device includes: a first substrate; a second substrate including a first opening and disposed above the first substrate; a first interposer disposed between the first substrate and the second substrate to electrically connect the first substrate and the second substrate, and providing a first space between the first substrate and the second substrate; a sealing member attached to cover the first opening; and a filler disposed between the first substrate and the second substrate. The sealing member includes an insertion area allowing a nozzle for injecting the filler to be inserted into the first opening, and a second opening allowing air to be introduced into the first space therethrough and a third opening allowing air to be exhausted from the first space therethrough are formed on at least one of the first substrate, the second substrate, or the first interposer.

According to various embodiments, a method of injecting a filler into a circuit board module, wherein the circuit board module includes: a first substrate; a second substrate including a first opening and disposed above the first substrate; an interposer disposed between the first substrate and the second substrate to connect the first substrate and the second substrate and providing a first space between the first substrate and the second substrate; and a sealing member attached to cover the first opening, and wherein a second opening allowing air to be introduced into the first space therethrough and a third opening allowing air to be exhausted from the first space therethrough are formed on at least one of the first substrate, the second substrate, or the first interposer, includes: preparing the circuit board module; injecting the filler through the first opening; and injecting air through the second opening.

### [Advantageous Effects]

According to various embodiments of the disclosure, a sealing member includes an insertion area into which a nozzle is inserted, which may allow injection of a filler when the nozzle is inserted, and substantially seal an inlet and thus prevent backflow of the filler when the nozzle is removed.

According to various embodiments of the disclosure, an application area for the filler may be set and backflow of the filler through the inlet or another opening may be prevented by controlling an air flow inside the printed circuit board.

The effects to be obtained from the disclosure are not limited to those mentioned above, and other effects not mentioned will be apparent to those skilled in the art from the following description.

### [Brief Description of Drawings]

FIG. 1 is a block diagram illustrating an electronic device in a network environment according to various embodiments.
FIG. 2 is a front perspective view illustrating an electronic device according to various embodiments of the disclosure.
FIG. 3 is a rear perspective view illustrating an electronic device according to various embodiments of the disclosure.
FIG. 4 is an exploded perspective view illustrating an electronic device according to various embodiments of the disclosure.
FIG. 5 is a diagram schematically illustrating a circuit board module provided with a backflow prevention structure according to various embodiments of the disclosure.
FIG. 6 is an exploded perspective view illustrating a circuit board module according to various embodiments of the disclosure.
FIG. 7 is a top view illustrating a circuit board module according to various embodiments.
FIG. 8 is a projection view illustrating a circuit board module as viewed from above according to various embodiments.
FIG. 9 is a perspective view illustrating partial application of a filler into the circuit board module of FIG. 8.
FIG. 10 is a perspective view illustrating full application of a filler into the circuit board module of FIG. 8.
FIG. 11 is a diagram illustrating a cross-section taken along line A-A' of FIG. 9.
FIG. 12 is a diagram illustrating a cross-section taken along line B-B' of FIG. 10.
FIG. 13 is a diagram illustrating a circuit board module according to another embodiment.
FIG. 14 is a diagram illustrating exemplary insertion areas of a sealing member according to various embodiments.
FIG. 15 is a diagram illustrating exemplary deformation-resistant areas of a sealing member according to various embodiments.
FIG. 16 is a cross-sectional view illustrating a process of injecting a filler through a sealing member according to various embodiments.
FIG. 17 is a cross-sectional view illustrating a nozzle and a process of injecting a filler through the nozzle according to another embodiment.
FIG. 18 is a cross-sectional view illustrating a nozzle with a sealing member and a process of injecting a filler through the nozzle according to another embodiment.
FIG. 19 is a diagram illustrating a backflow prevention structure according to various embodiments.
FIG. 20 is a diagram illustrating a backflow prevention structure according to another embodiment.
FIG. 21 is a diagram illustrating a backflow prevention structure according to another embodiment.
FIG. 22 is a diagram illustrating a first exemplary multi-layer stacked circuit board module according to various embodiments.
FIG. 23 is a diagram illustrating a second exemplary multi-layer stacked circuit board module according to various embodiments.
FIG. 24 is a diagram illustrating a third exemplary multi-layer stacked circuit board module and injection of a filler thereinto according to various embodiments.
FIG. 25 is a diagram illustrating a fourth exemplary multi-layer stacked circuit board module and injection of a filler thereinto according to various embodiments.
FIG. 26 is a diagram illustrating a fifth exemplary multi-layer stacked circuit board module and injection of a filler thereinto according to various embodiments.
FIG. 27 is a diagram illustrating a sixth exemplary multi-layer stacked circuit board module and injection of a filler thereinto according to various embodiments.
FIG. 28 is a flowchart illustrating a method of injecting a filler into a circuit board module to fabricate a circuit board module to which a filler is applied according to various embodiments.

### [Mode for Carrying out the Invention]

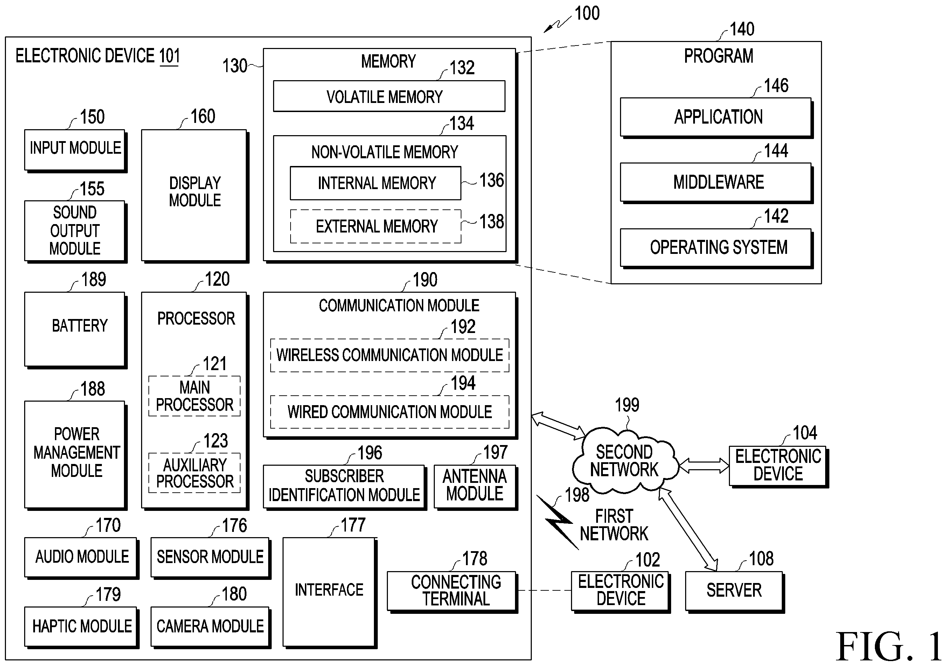

FIG. 1 is a block diagram illustrating an electronic device in a network environment according to various embodiments of the disclosure.

Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form an mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1^{st}" and "2^{nd}", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

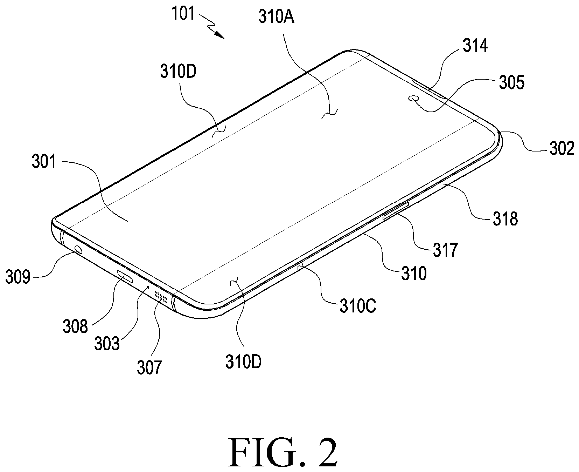

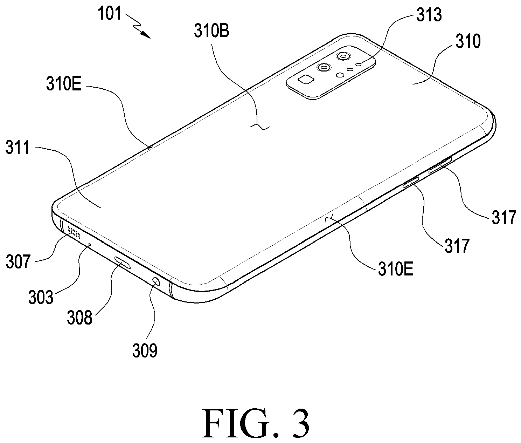

FIG. 2 is a front perspective view illustrating an electronic device according to various embodiments of the disclosure. FIG. 3 is a rear perspective view illustrating an electronic device according to various embodiments of the disclosure.

Referring to FIGS. 2 and 3, the electronic device 101 according to an embodiment may include a housing 310 which includes a front surface 310A, a rear surface 310B, and side surfaces 310C surrounding a space between the front surface 310A and the rear surface 310B. In another embodiment (not shown), the housing 310 may refer to a structure that forms a portion of the front surface 310A of FIG. 2, the rear surface 310B of FIG. 3, and the side surfaces 310C. According to an embodiment, at least a portion of the front surface 310A may be formed by a front plate 302 (e.g., a glass plate or polymer plate including various coating layers) which is at least partially substantially transparent. The rear surface 310B may be formed by a rear plate 311. The rear plate 311 may be formed of, for example, glass, ceramic, a polymer, a metal (e.g., aluminum, stainless steel (STS), or magnesium), or a combination of at least two of these materials. The side surfaces 310C may be coupled with the front plate 302 and the rear plate 311 and formed by a side bezel structure (or "side member") 318 including a metal and/or a polymer. In a certain embodiment, the rear plate 311 and the side bezel structure 318 may be integrally formed and include the same material (e.g., glass, a metal material such as aluminum, or ceramic).

In the illustrated embodiment, the front plate 302 may include two first edge areas 310D, which are bent and extend seamlessly from the front surface 310A toward the rear plate 311, at both long edge ends thereof. In the illustrated embodiment (see FIG. 3), the rear plate 311 may include two second edge areas 310E, which are bent and extend seamlessly from the rear surface 310B toward the front plate 302, at both long edge ends thereof. In a certain embodiment, the front plate 302 (or the rear plate 311) may include only one of the first edge areas 310D (or the second edge areas 310E). In another embodiment, some of the first edge areas 310D or the second edge areas 310E may not be included. In these embodiments, when viewed from the sides of the electronic device 101, the side bezel structure 318 may have a first thickness (or width) on a side surface that does not include any of the above first edge areas 310D or second edge areas 310E, and a second thickness less than the first thickness on a side surface that includes the above first edge areas 310D or second edge areas 310E.

According to an embodiment, the electronic device 101 may include at least one of a display 301 (e.g., the display device 160 f FIG. 1), audio modules 303, 307, and 314 (e.g., the audio module 170 of FIG. 1), a sensor module (e.g., the sensor module 176 of FIG. 1), camera modules 305, 312, and 313 (e.g., the camera module 180 of FIG. 1), key input devices 317 (e.g., the input device 150 of FIG. 1), or connector holes 308 and 309 (e.g., the connecting terminal 178 of FIG. 1). In a certain embodiment, the electronic device 101 may not be provided with at least one (e.g., the connector hole 309) of the components or may additionally include other components.

The display 301 may be visually exposed, for example, through a substantial portion of the front plate 302. In a certain embodiment, at least a portion of the display 301 may be exposed through the front surface 310A and the front plate 302 forming the first edge areas 310D of the side surfaces 310C. In a certain embodiment, a corner of the display 301 may be formed substantially in the same shape as that of an adjacent periphery of the front plate 302. In another embodiment (not shown), a gap between the periphery of the display 301 and the periphery of the front plate 302 may be substantially equal to increase the visually exposed area of the display 301.

According to an embodiment, a surface (or the front plate 302) of the housing 310 may include a screen display area formed as the display 301 is visually exposed. For example, the screen display area may include the front surface 310A and the first edge areas 310D.

In another embodiment (not shown), a recess or an opening may be formed in a portion of the screen display area (e.g., the front surface 310A and the first edge rears 310D), and at least one of the audio module 314, a sensor module (not shown), a light emitting element (not shown), or the camera module 305, which is aligned with the recess or the opening, may be included. In another embodiment (not shown), at least one of the audio module 314, a sensor module (not shown), the camera modules 305, a fingerprint sensor (not shown), or a light emitting element (not shown) may be included on a rear surface of the screen display area of the display 301.

According to an embodiment, at least one camera module 305 and 312 may be disposed toward the bottom of the display 301. For example, the first camera module 305 may be disposed in at least a partial area of the display 301 corresponding to a camera field of view (FOV). As the first camera module 305 is disposed in at least a portion of the display 301 corresponding to the camera FOV, the position of the first camera module 305 may not be visually distinguished (or exposed). According to an embodiment, when the display 301 is viewed from the first surface 310A, the first camera module 305 may be disposed in at least a portion of the display 301, corresponding to the camera FOV, and thus obtain an image of an external subject without being visually exposed to the outside. For example, the first camera module 305 may be an under display camera (UDC).

In an embodiment, the electronic device 101 may include a display (not shown) that is slidably disposed and provides a screen (e.g., the display area). For example, the display area of the electronic device 101 may be an area that is visually exposed and allows for image output. In an example, the electronic device 101 may adjust the display area according to the movement of a sliding plate (not shown) or the movement of the display. For example, the electronic device 101 may include a rollable electronic device configured to selectively expand the display area by allowing at least a portion (e.g., the housing 310) of the electronic device 101 to be at least partially slidable. This display may also be referred to as a slide-out display or an expandable display, for example.

In another embodiment (not shown), the display 301 may be incorporated with or disposed adjacent to a touch sensing circuit, a pressure sensor capable of measuring the intensity (pressure) of a touch, and/or a digitizer that detects a magnetic field-based stylus pen. In a certain embodiment, at least some of the key input devices 317 may be disposed in the first edge areas 310D and/or the second edge areas 310E.

According to an embodiment, the audio modules 303, 307, and 314 may include, for example, a microphone hole 303 and speaker holes 307 and 314. A microphone for obtaining an external sound may be disposed in the microphone hole 303, and in a certain embodiment, a plurality of microphones may be disposed to detect the direction of a sound. The speaker holes 307 and 314 may include an external speaker hole 307 and a receiver hole 314 for calls. In a certain embodiment, the speaker holes 307 and 314 and the microphone hole 303 may be implemented as a single hole, or a speaker (e.g., a piezo speaker) may be included without the speaker holes 307 and 314. The audio modules 303, 307, and 314 are not limited to the above-described structure, and may be subject to various design modifications, such as mounting only some audio module or adding a new audio module, according to the structure of the electronic device 101.

According to an embodiment, the sensor module (not shown) may generate an electrical signal or data value corresponding to an internal operating state of the electronic device 101 or an external environmental state. The sensor module (not shown) may include, for example, a first sensor module (e.g., a proximity sensor) and/or a second sensor module (e.g., a fingerprint sensor), disposed on the front surface 310A of the housing 310, and/or a third sensor module (e.g., a heart rate monitor (HRM) sensor) disposed on the rear surface 310B of the housing 310 and/or a fourth sensor module (e.g., a fingerprint sensor). In a certain embodiment (not shown), a fingerprint sensor may be disposed on the rear surface 310B as well as on the front surface 310A (e.g., the display 301) of the housing 310. The electronic device 101 may further include a sensor module which is not shown, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor. The sensor module is not limited to the above-described structure, and may be subject to various design modifications, such as mounting only some sensor module or adding a new sensor module, according to the structure of the electronic device 101.

According to an embodiment, the camera modules 305, 312, and 313 may include a front camera module 305 disposed on the front surface 310A of the electronic device 101, and a rear camera module 312 disposed on the rear surface 310B, and/or a flash 313. The camera modules 305 and 312 may include one or more lenses, an image sensor, and/or an image signal processor. The flash 313 may include, for example, a light emitting diode (LED) or a xenon lamp. In a certain embodiment, two or more lenses (an IR camera, a wide-angle lens, and a telephoto lens) and image sensors may be arranged on one surface of the electronic device 101. The camera modules 305, 312, and 313 are not limited to the above-described structure, and may be subject to various design modifications, such as mounting only some camera module or adding a new camera module, according to the structure of the electronic device 101.

According to an embodiment, the electronic device 101 may include a plurality of camera modules (e.g., a dual camera or a triple camera) each having a different property (e.g., FOV) or function. For example, a plurality of camera modules 305 and 312 including lenses with different FOVs may be configured, and the electronic device 101 may control to change the FOVs of the camera modules 305 and 312 implemented in the electronic device 101 based on a user selection. For example, at least one of the plurality of camera modules 305 and 312 may be a wide-angle camera, and at least another one may be a telephoto camera. Similarly, at least one of the plurality of camera modules 305 and 312 may be a front camera, and at least another one may be a rear camera. Additionally, the plurality of camera modules 305 and 312 may include at least one of a wide-angle camera, a telephoto camera, or an IR camera (e.g., a time of flight (TOF) camera or a structured light camera). According to an embodiment, the IR camera may operate as at least a portion of the sensor module. For example, the TOF camera may operate as at least a portion of a sensor module (not shown) to detect the distance to a subject.

According to an embodiment, the key input devices 317 may be arranged on the side surfaces 310C of the housing 310. In another embodiment, the electronic device 101 may not include some or any of the key input devices 317, and the key input devices 317 which are not included may be implemented in other forms such as soft keys on the display 301. In a certain embodiment, the key input devices may include a sensor module (not shown) disposed on the second surface 310B of the housing 310.

According to an embodiment, the light emitting element (not shown) may be disposed, for example, on the front surface 310A of the housing 310. The light emitting element (not shown) may provide, for example, state information about the electronic device 101 in the form of light. In another embodiment, the light emitting element (not shown) may provide, for example, a light source interworking with an operation of the front camera module 305. The light emitting element (not shown) may include, for example, an LED, an IR LED, and/or a xenon lamp.

According to an embodiment, the connector holes 308 and 309 may include a first connector hole 308 capable of accommodating a connector (e.g., a universal serial bus (USB) connector) for transmitting and receiving power and/or data to and from an external electronic device and/or a second connector hole (e.g., an earphone jack) 309 capable of accommodating a connector for transmitting and receiving an audio signal to and from an external electronic device.

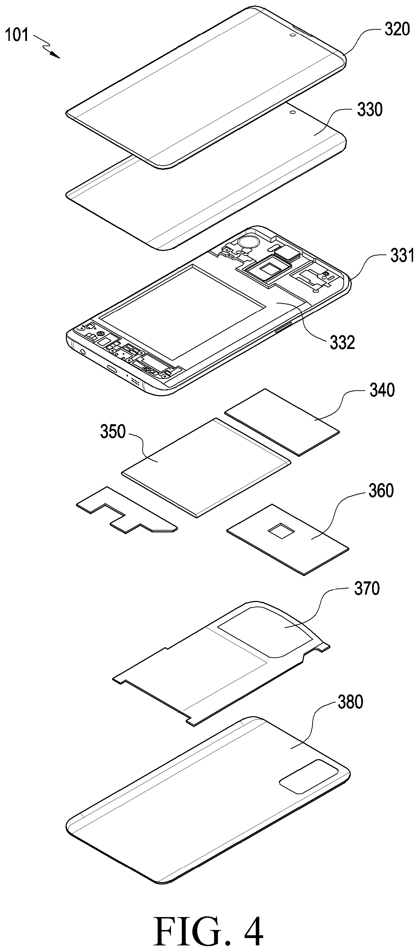

According to an embodiment, some camera modules 305 of the camera modules 305 and 312 and/or some sensor modules of the sensor modules (not shown) may be disposed to be exposed to the outside through at least a portion of the display 301. For example, the camera module 305 may include a punch hole camera disposed inside a hole or recess formed on the rear surface of the display 301. According to an embodiment, the camera module 312 may be disposed inside the housing 310, such that a lens is exposed to the second surface 310B of the electronic device 101. For example, the camera module 312 may be placed on a PCB (e.g., a PCB 340 of FIG. 4).

According to an embodiment, the camera module 305 and/or the sensor module may be disposed in contact with an external environment through a transparent area from the internal space of the electronic device 101 to the front plate 302 of the display 301. Additionally, some sensor module (not shown) may be disposed to perform its function in the internal space of the electronic device, without being visually exposed through the front plate 302.

FIG. 4 is an exploded perspective view illustrating an electronic device according to various embodiments of the disclosure.

Referring to FIG. 4, the electronic device 101 (e.g., the electronic device 101 of FIGS. 1 to 3) according to various embodiments may include a side bezel structure 331 (e.g., the side bezel structure 318 of FIG. 2), a first support member 332, a front plate 320 (e.g., the front plate 302 of FIG. 2), a display 330 (e.g., the display 301 of FIG. 2), the PCB 340 (e.g., a PCB, a flexible PCB (FPCB), or a rigid flexible PCB (RFPCB)), a battery 350 (e.g., the battery 189 of FIG. 1), a second support member 360 (e.g., a rear case), an antenna 370 (e.g., the antenna module 197 of FIG. 1), and a rear plate 380 (e.g., the rear plate 311 of FIG. 2). In a certain embodiment, the electronic device 101 may not be provided with at least one (e.g., the first support member 332 or the second support member 360) of the components or may additionally include other components. At least one of the components of the electronic device 101 may be the same as or similar to at least one of the components of the electronic device 101 of FIG. 2 or FIG. 3, and a redundant description will be avoided herein.

According to various embodiments, the first support member 332 may be disposed within the electronic device 101 and connected to the side bezel structure 331, or may be integrally formed with the side bezel structure 331. The first support member 332 may be formed of, for example, a metal material and/or a non-metal (e.g., polymer) material. The first support member 332 may have one surface coupled with the display 330 and the other surface coupled with the PCB 340.

According to various embodiments, a processor, memory, and/or an interface may be mounted on the PCB 340. The processor may include at least one of, for example, a CPU, an application processor, a graphics processing unit, an image signal processor, a sensor hub processor, or a communication processor. According to various embodiments, the PCB 340 may include a flexible PCB type radio frequency cable (FRC). For example, the PCB 340 may be disposed on at least a portion of the first support member 332 and electrically coupled to an antenna module (e.g., the antenna module 197 of FIG. 1) and a communication module (e.g., the communication module 190 of FIG. 1).

According to an embodiment, the memory (e.g., the memory 130 of FIG. 1) may include, for example, volatile memory or non-volatile memory.

According to an embodiment, the interface (e.g., the interface 177 of FIG. 1) may include, for example, a HDMI, a USB interface, a secure digital (SD) card interface, and/or an audio interface. The interface may electrically or physically connect the electronic device 101 to an external electronic device, for example, and include a USB connector, an SD card/MMC connector, or an audio connector.

According to various embodiments, the battery 350 (e.g., the battery 189 of FIG. 1), which is a device for supplying power to at least one component of the electronic device 101, may include, for example, a non-rechargeable primary cell, a rechargeable secondary cell, or a fuel cell. At least a portion of the battery 350 may be disposed substantially on the same plane as the PCB 340, for example. The battery 350 may be integrally disposed within the electronic device 101 or disposed detachably from the electronic device 101.

According to various embodiments, the second support member 360 (e.g., the rear case) may be disposed between the PCB 340 and the antenna 370. For example, the second support member 360 may include one surface coupled with at least one of the PCB 340 or the battery 350 and the other surface coupled with the antenna 370.

According to various embodiments, the antenna 370 (e.g., the antenna module 197 of FIG. 1) may be disposed between the rear plate 380 and the battery 350. The antenna 370 may include, for example, a near field communication (NFC) antenna, a wireless charging antenna, and/or a magnetic secure transmission (MST) antenna. The antenna 370 may, for example, perform sort-range communication with an external device or wirelessly transmit and receive power for charging to and from an external device. In another embodiment, an antenna structure may be formed by a portion or combination of the side bezel structure 331 and/or the first support member 332.

According to various embodiments, the rear plate 380 may form at least a portion of the rear surface (e.g., the second surface 310B of FIG. 3) of the electronic device 101.

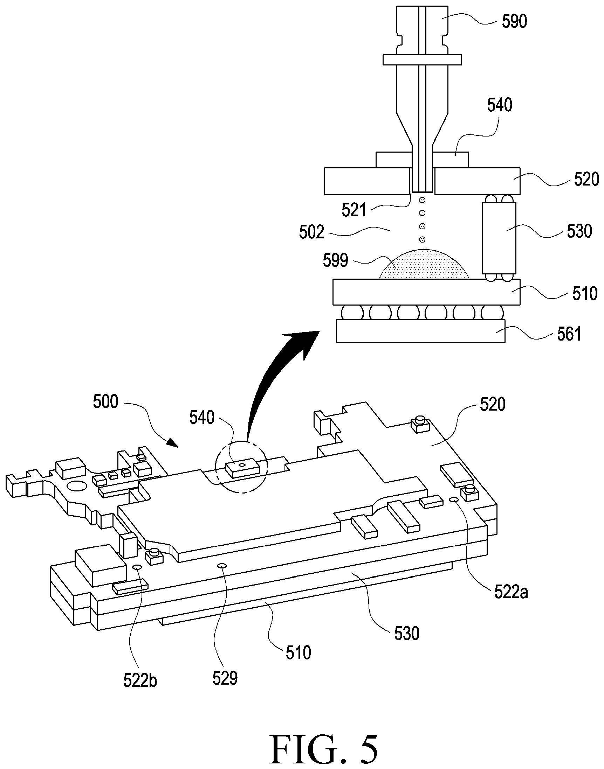

According to various embodiments, a filler may be applied to the PCB 340 to prevent problems caused by heating of components mounted on the PCB 340. For example, the filler may be a material with high heat transfer efficiency. Further, the filler may be a liquid-state or semi-solid state material. For example, the filler may include, but not limited to, a resin, a gel-type thermal interface material (TIM), and a solid-state TIM. In other words, the filler according to an embodiment may include any liquid-state or semi-solid state material and be interpreted to mean any member which may be disposed within the PCB 340 to perform a function of increasing the strength of the PCB 340 and dissipating heat of the PCB 340. According to various embodiments, the PCB 340 may be provided with a backflow prevention structure 500 (see FIG. 5) to prevent backflow of a liquid-state filler during application of the filler.

In the following description, the backflow prevention structure 500 (see FIG. 5) provided on the PCB 340 will be described with reference to the drawings.

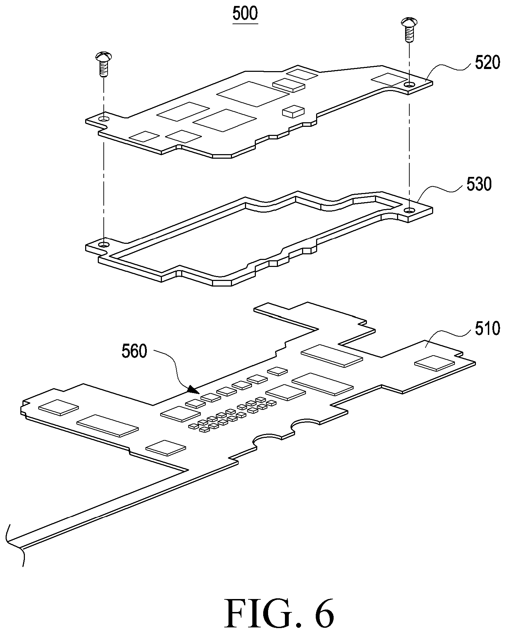

FIG. 5 is a schematic diagram illustrating a PCB provided with a backflow prevention structure according to various embodiments of the disclosure. FIG. 6 is an exploded perspective view illustrating a circuit board module according to various embodiments.

Referring to FIGS. 5 and 6, a structure for preventing backflow of a filler may be provided in the circuit board module 500. According to various embodiments, the circuit board module 500 may include a first substrate 510, a second substrate 520, an interposer 530 disposed between the first substrate 510 and/or the second substrate 520, and components 560 mounted on the first substrate 510 and/or the second substrate.

The circuit board module 500 of FIGS. 5 and 6 may be wholly or partially identical or similar to the PCB 340 of FIG. 4, and thus a redundant description will be avoided.

According to various embodiments, the circuit board module 500 may include a sealing member 540 and a plurality of openings 522a and 522b. All or some of the sealing member 540 and the plurality of openings 522a and 522b may be combined to provide the structure for preventing backflow of a filler.

According to various embodiments, the circuit board module 500 may include an inlet 521. For example, the inlet 521 may be formed on the second substrate 520. According to an embodiment, a nozzle 590 for injecting a filler may be inserted into the inlet 521. With the nozzle 590 inserted into the inlet 521, a filler 599 may be applied between the first substrate 510 and the second substrate 520.

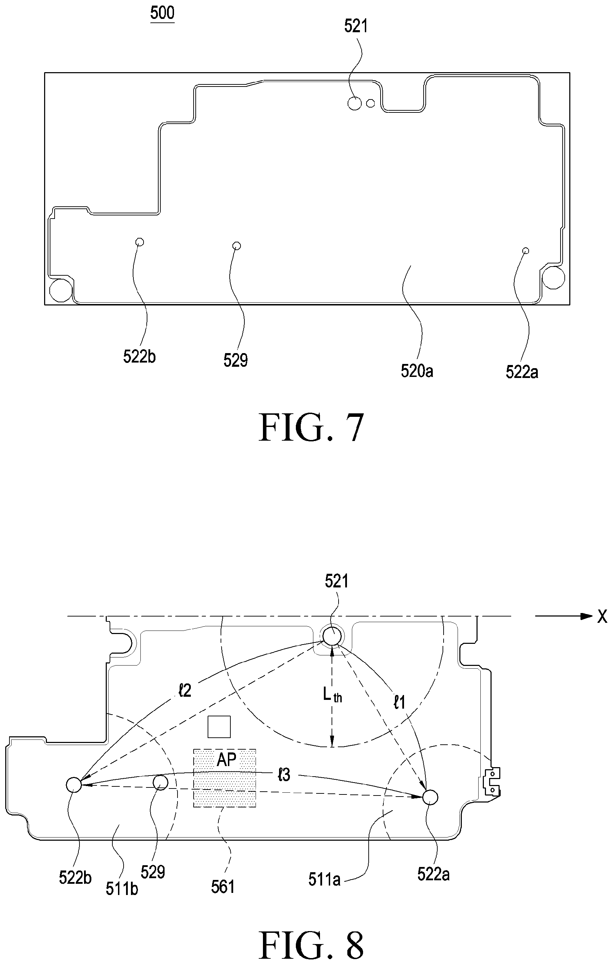

According to various embodiments, the sealing member 540 may be disposed to cover all or a portion of the inlet 521. For example, the sealing member 540 may be attached to a top surface 520a (see FIG. 7) of the second substrate 520 to cover the inlet 521. The sealing member 540 may be attached to the top surface 520a (see FIG. 7) of the second substrate 520 by the surface mount technology (SMT) using a solder or adhesive. According to an embodiment, the nozzle 590 may penetrate both the sealing member 540 and the inlet 521 and apply the filler 599, while being inserted into the circuit board module 500. The sealing member 540 may cover the inlet 521 and prevent backflow of the applied filler 599.

According to various embodiments, some of the various components 560 mounted on the first substrate 510 and/or the second substrate 520 may be a heat source 561 that generates heat. For example, the heat source 561 may be at least one of a power management integrated circuit (PMIC), a power amplifier (PAM), an application processor (AP), a communication processor (CP), a charger integrated circuit (charger IC), a display driver integrated circuit (DDI), or a communication circuit (e.g., a transceiver, an active communication device, or a passive communication device).

According to various embodiments, the circuit board module 500 may include a first opening 522a and a second opening 522b. For example, the first opening 522a and the second opening 522b may be formed on the second substrate 520. However, this is only exemplary, and the circuit board module 500 may include only one opening or three or more openings.

According to an embodiment, air may be introduced into at least one of the first opening 522a or the second opening 522b, and the introduced air may be exhausted out of the other opening. For example, the first opening 522a may be an intake opening and the second opening 522b may be an exhaust opening. Air introduced through the first opening 522a may flow within an internal space 502 of the circuit board module 500 and exit through the second opening 522b. As a result, the filler 599 applied to the internal space 502 may be applied more widely. For example, in a manufacturing process of the circuit board module 500, an application range of the filler 599 may be controlled by adjusting injection of external air through the first opening 522a and exhaust of internal air of the circuit board module 500 through the second opening 522b. This will be described in greater detail below.

According to an embodiment, all or some of the first opening 522a and/or the second opening 522b may provide an exhaust path for thermally expanded air from the internal space 502. For example, the first opening 522a and/or the second opening 522b may provide an exhaust path for thermally expanded air to prevent a situation in which air present within the internal space 502 may thermally expand and cause backflow of the filler 599.

According to various embodiments, the circuit board module 500 may include an inspection hole 529. For example, the inspection hole 529 may be formed on the second substrate 520. The inspection hole 529 according to an embodiment may provide a path through which an automated circuit board module manufacturing system may determine whether the filler 599 has been applied to a required area.

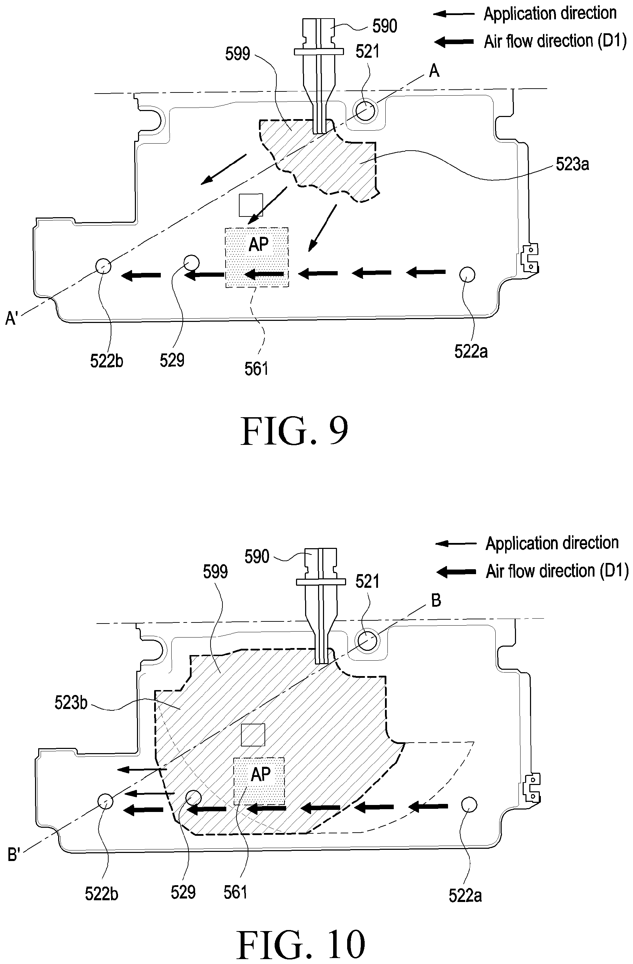

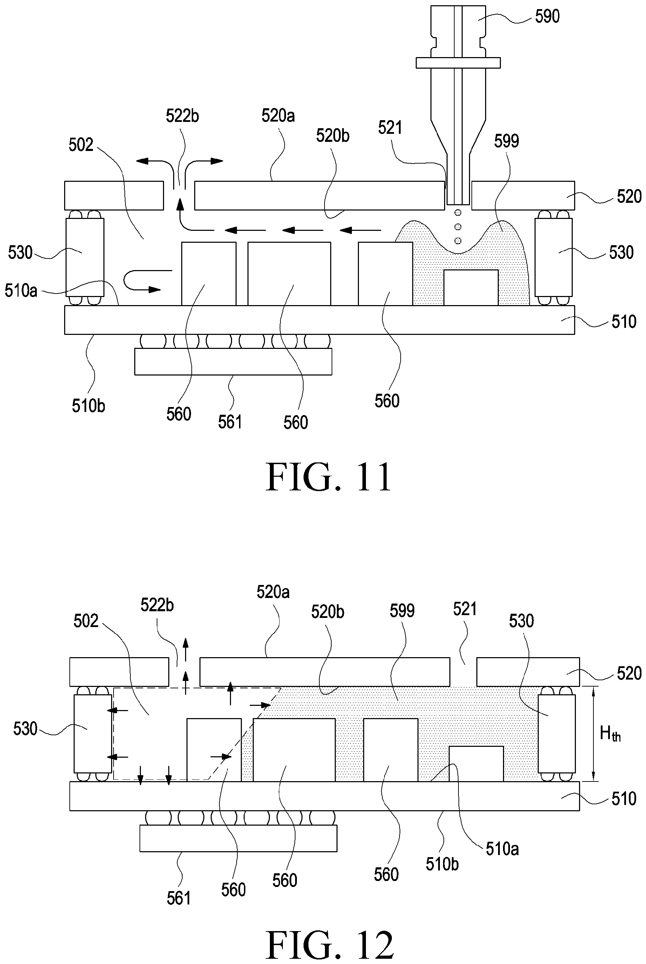

FIG. 7 is a top view illustrating a circuit board module according to various embodiments. FIG. 8 is a projection view illustrating a circuit board module as viewed from above according to various embodiments. FIG. 9 is a diagram illustrating partial application of a filler to the circuit board module of FIG. 8. FIG. 10 is a diagram illustrating full application of a filler to the circuit board module of FIG. 8. FIG. 11 is a diagram illustrating a cross-section taken along line A-A' of FIG. 9. FIG. 12 is a diagram illustrating a cross-section taken along line B-B' of FIG. 10.

Referring to FIGS. 7 to 11, air entering or exiting from the plurality of openings 522a and 522b may adjust a direction of application of the filler 599. The circuit board module 500 of FIGS. 7 to 11 may be wholly or partially identical or similar to the circuit board module 500 of FIGS. 5 and 6, and thus a redundant description will be avoided.

Referring to FIGS. 7 and 8, a distance between the inlet 521 and the first opening 522a and a distance between the inlet 521 and the second opening 522b may be set to be equal to or greater than a threshold distance Lth. When the distance between the inlet 521 through which the filler 599 is injected and the first opening 522a or the second opening 522b is equal to or less than the threshold distance Lth, the filler 599 may flow back through the first opening 522a or the second opening 522b. According to an embodiment, the first opening 522a and/or the second opening 522b may be disposed to be spaced apart from the inlet 521 by the threshold distance Lth or more, thereby preventing the filler 599 from flowing back through the first opening 522a and/or the second opening 522b. In other words, the threshold distance Lth may refer to a minimum distance at which the filler 599 does not flow back through the first opening 522a and/or the second opening 522b during a process of injecting the filler 599. According to an embodiment, the threshold distance Lth may be determined by at least one or a combination of some of an injection rate, an injection time, and/or an injection volume of the filler 599 discharged from the nozzle 590. According to an embodiment, the first opening 522a may be formed spaced apart from the inlet 521 by a first distance l1 equal to or greater than the threshold distance Lth. Further, the second opening 522b may be formed spaced apart from the inlet 521 by a second distance l2 equal to or greater than the threshold distance Lth. Further, according to an embodiment, the distance between the inlet 521 and the first opening 522a or the distance between the inlet 521 and the second opening 522b may be less than the distance between the first opening 522a and the second opening 522b.

According to various embodiments, the first opening 522a and/or the second opening 522b may be formed within specific respective areas of the second substrate 510. For example, the first opening 522a may be formed on the second substrate 520 at a position corresponding to a first area 511a. Additionally, the second opening 522b may be formed on the second substrate at a position corresponding to a second area 511b. For example, the first area 511a and the second area 511b may refer to areas on the first substrate 510, in which no filler is required to be applied after the filler injection is completed. Alternatively, the first area 511a and the second area 511b may refer to areas in which air is thermally expanded by the heat source 561 or by curing of the filler 599. As the first opening 522a and/or the second opening 522b is formed at the position corresponding to the first area 511a and/or the second area 511b, it is possible to discharge air from the overheated internal space 502 to the outside.

According to various embodiments, the heat source 561 may be disposed between the first opening 522a and the second opening 522b in a direction of a first axis (x axis) (see FIG. 8). The heat source 561 may be disposed on a front surface 510a or a rear surface 510b of the first substrate 510. For example, the first axis may refer to a longitudinal axis of the circuit board module 500. According to an embodiment, the filler 599 may be applied along a direction corresponding to a direction of an air flow in the internal space 502. For example, air entering the first opening 522a may flow in a direction corresponding to a direction from the first opening 522a to the second opening 522b. As a result, when the heat source 561 is disposed between the first opening 522a and the second opening 522b in the direction of the first axis (x axis), the filler 599 may be applied to an area corresponding to the heat source 561.

According to various embodiments, the inspection hole 529 may be formed between the first opening 522a and the second opening 522b. According to an embodiment, the inspection hole 529 may be formed near a boundary of the second area 511b. For example, the automated circuit board module manufacturing system may include various imaging devices (e.g., a camera) or various distance sensors (e.g., an IR sensor) and determine whether the filler 599 has been applied to a required area, using the inspection hole 529. Similarly to the case of the second area 511b, the inspection hole 529 may of course be formed near a boundary of the first area 511a. While imaging devices and distance sensors have been described as an example, it will be understood that a variety of sensors may be used to identify the application of the filler 599 through the inspection hole 529.

Referring to FIGS. 9 and 10, a process of applying the filler 599 to the internal space 502 is illustrated.

When the filler 599 is injected from the nozzle 590, the filler 599 may initially be deposited over a first application area 523a, which is an area near the inlet 521. When the filler 599, which is a highly viscous material, is applied to the first application area 523a near the inlet 521, it may be necessary to cause a flow of the filler 599 such that the filler 599 is applied over a desired area.

According to various embodiments, air through the first opening 522a and the second opening 522b may induce the flow of the filler 599. For example, when air introduced through the first opening 522a travels in a first direction D1 and exits through the second opening 522b, the application area of the filler 599 may also change to correspond to the first direction D1. According to an embodiment, the filler 599 applied to the first application area 523a may flow in a direction corresponding to the first direction D1 by air traveling in the first direction D1 and be applied to a second application area 523b. According to an embodiment, the second application area 523b may refer to an area to which the filler 599 is applied, as required by the industry. According to an embodiment, the second application area 523b may be predetermined according to industry requirements. For example, the second application area 523b may be determined so as to overlap an area corresponding to the heat source 561. In another example, the second application area 523b may be determined such that it is not disposed under the first opening 522a and/or the second opening 522b. In another example, the second application area 523b may be determined in consideration of an injection amount or injection time of the filler 599 in the manufacturing process. However, this is merely exemplary, and it will be understood that the second application area 523b may be determined by the above examples in combination or by other industry requirements.

According to an embodiment, an air flow in the internal space 502 may be controlled by closing or opening all or a portion of the first opening 522a and/or the second opening 522b. For example, the filler 599 may be induced to flow in a direction in which the first opening 522a is disposed by closing the second opening 522b and opening only the first opening 522a.

According to various embodiments, the position of the first opening 522a and/or the second opening 522b may be determined to ensure that the filler 599 is applied to an area corresponding to the heat source 561 among areas of the top surface 510a (see FIGS. 11 and 12) of the first substrate 510. Further, the direction of the air flow within the internal space 502 may be determined through the first opening 522a and/or the second opening 522b. The positions of the first opening 522a and the second opening 522b may also be determined such that the filler 599 may be applied onto the various components 560 disposed on the top surface 510a (see FIGS. 11 and 12) of the first substrate 510 as well as the area corresponding to the heat source 561.

According to various embodiments, in the manufacturing process of the circuit board module 500, a process performing entity may introduce air through the first opening 522a in response to the injection of the filler 599. For example, the process performing entity may be an automated circuit board module manufacturing system or a human, and the following description of the disclosure will focus on an automated circuit board module manufacturing system for ease of description. The process of applying the filler 599 by air introduced through the first opening 522a is similar to that described above. According to an embodiment, in the manufacturing process of the circuit board module 500, the process performing entity may determine through the inspection hole 529 whether the filler 599 has been applied over a required area. For example, the circuit board module manufacturing system may use an imaging device or a distance sensor to determine whether the filler 599 has been applied at a position corresponding to the inspection hole 529. According to an embodiment, the inspection hole 529 may be located near the boundary of the second application area 523b. For example, the inspection hole 529 may be formed on an inward side of the second application area 523b adjacent to the boundary of the second application area 523b, and the circuit board module manufacturing system may determine, through an imaging device or a distance sensor, whether the filler 599 has been applied to the vicinity of the boundary of the second application area 523b. According to an embodiment, the circuit board module manufacturing system may stop injecting the filler 599 and/or introducing air when determining that the filler 599 has been applied up to the area corresponding to the inspection hole 529, or continue injecting the filler 599 and/or introducing air when determining that the filler 599 has not been applied up to the area corresponding to the inspection hole 529.

Referring to FIGS. 11 and 12, a process of injecting the filler 599 into the circuit board module 500 is illustrated in a cross-sectional view of the circuit board module 500.

According to various embodiments, the first opening 522a (see FIG. 7) and the second opening 522b may adjust the pressure of the internal space 502. For example, due to curing of the filler 599, a high temperature environment such as 130 to 140°C may be created within the internal space 502. According to an embodiment, in the internal space 502 where a high temperature environment is created, air may expand or gas may be generated from the filler 599 in the internal space 502, causing the filler 599 to flow back to the inlet 521. According to an embodiment, the first opening 522a and/or the second opening 522b may prevent the pressure within the internal space 502 from increasing during the curing of the filler 599. For example, the first opening 522a and/or the second opening 522b may provide a path through which the expanded air may escape from the internal space 502 in the high temperature environment. In another example, the first opening 522a and/or the second opening 522b may provide a path through which gases generated from the filler 599 may exit during the curing operation.

According to various embodiments, the filler 599 may be disposed to be deposited to or below a predetermined height Hth within the internal space 502. For example, the predetermined height Hth may refer to a height from the top surface 510a of the first substrate to a bottom surface 520b of the second substrate. For example, the deposition height of the filler 599 may be adjusted by adjusting the pressure within the internal space 502 through the first opening 522a and/or the second opening 522b, as described above. In another example, the filler 599 may be applied to be located between the top surface 510a of the first substrate and a top surface 520a of the second substrate (or a top end of the inlet 521).

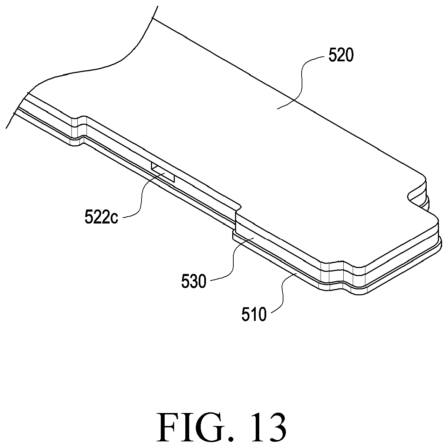

FIG. 13 is a diagram illustrating a circuit board module according to another embodiment.

Referring to FIG. 13, the circuit board module 500 may include a third opening 522c. The circuit board module 500 of FIG. 13 is wholly or partially identical or similar to the circuit board module 500 of FIG. 5, and thus a redundant description will be avoided.

According to various embodiments, the third opening 522c may be formed on the interposer 530. The third opening 522c may provide the same function as the first opening 522a and/or the second opening 522c described above. According to an embodiment, the third opening 522c may be formed together with at least some or all of the first opening 522a and/or the second opening 522c. For example, the first opening 522a may be formed on the second substrate 520, and the third opening 522c may be formed on the interposer 530. According to an embodiment, a plurality of third openings 522c may be formed on the interposer 530. For example, some of the plurality of third openings 522c formed on the interposer 530 may perform a function similar to the first opening 522a, and others may perform a function similar to the second opening 522b. According to various embodiments, the third opening 522c may be used as an inlet for insertion of the nozzle 590.

In the following description herein, exemplary sealing members according to various embodiments will be described with reference to the drawings.

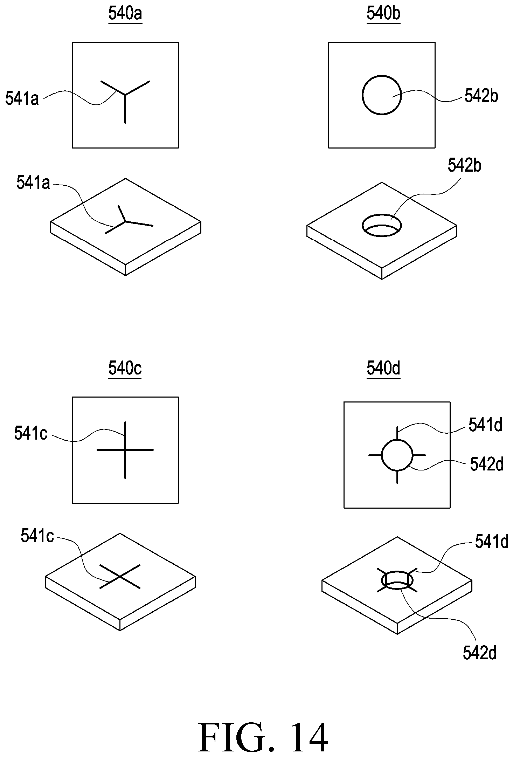

FIG. 14 is a diagram illustrating exemplary insertion areas of a sealing member according to various embodiments.

Referring to FIG. 14, the sealing member 540 may include insertion areas 541a to 541d. The sealing member 540 of FIG. 14 may be wholly or partially identical or similar to the sealing member 540 of FIG. 5, and thus a redundant description will be avoided.

According to various embodiments, the insertion areas 541a, 541c, and 541d may be formed near a center area of the sealing member 540. According to an embodiment, an insertion area 541 may provide a path through which the nozzle 560 is inserted into the inlet 521.

According to various embodiments, the insertion areas 541a and 541c may be provided in the form of slits. According to an embodiment, the insertion areas 541a and 541c may vary in area in response to an external force. For example, the insertion areas 541a and 541c may maintain a substantially gap-free shape when no external force is applied, and may be widened to create a space for insertion of the nozzle when an external force is applied. According to an embodiment, the sealing member 540 may include an elastic, resilient material (e.g., rubber) such that when the insertion areas 541a and 541c are formed in the form of slits, they may be changed in shape upon application of an external force and return to their original shapes after the application of the external force ends. As the insertion areas 541a and 541c are formed as slits, it is possible to insert the nozzle 560, and after completion of application of the filler 599, the shapes of the insertion areas 541a and 541c may be restored, thereby preventing backflow of the filler 599. According to an embodiment, the insertion areas 541a and 541c may be formed by allowing a thin blade to penetrate therethrough or by etching a portion of the sealing member 540. However, this is only exemplary, and the slit-shaped insertion areas 541a and 541c may be formed in various manners.

According to various embodiments, the slit-shaped insertion areas 541a and 541c may have a symmetrical shape. In an example, the insertion area 541c may be cross-shaped. In another example, the insertion area 541a may be Y-shaped. As the slit-shaped insertion areas 541a and 541c have a symmetrical shape, insertion of the nozzle 560 may be facilitated or deformation of the insertion areas 541a and 541c may be minimized during removal of the nozzle 560.

According to various embodiments, the sealing member 540b may include an insertion opening 542b. The insertion opening 542b may be formed in the center area of the sealing member 540b. According to an embodiment, the insertion opening 542b may be circular. However, the insertion opening 542b may have a polygonal shape, not limited to a circle, and various other shapes are available, which provide an insertion path for the nozzle 560. According to an embodiment, the width of the insertion opening 542b may be less than the width of a distal end of the nozzle 560. As a result, the nozzle 560 and the insertion opening 542b may be brought into close contact during injection of the filler 599. For example, when the sealing member 540b is formed of an elastic material, the insertion opening 542b may expand upon insertion of the nozzle, and the insertion opening 542b and the nozzle 560 may be brought into close contact by an elastic force that restores the expanded insertion opening 542b.

According to various embodiments, a sealing member 540d may include a slit-shaped insertion area 541d and an insertion opening 542d. According to an embodiment, the insertion area 541d may be formed around the insertion opening 542d. Alternatively, centered on the insertion opening 542d, the insertion area 541d may be formed to surround the insertion opening 542d. According to an embodiment, the insertion opening 542d and the insertion area 541d may be formed to be connected. The description of the insertion area 541d and the insertion opening 542d may be adapted from the description of the insertion areas 541a and 541c and the insertion opening 542b described above.

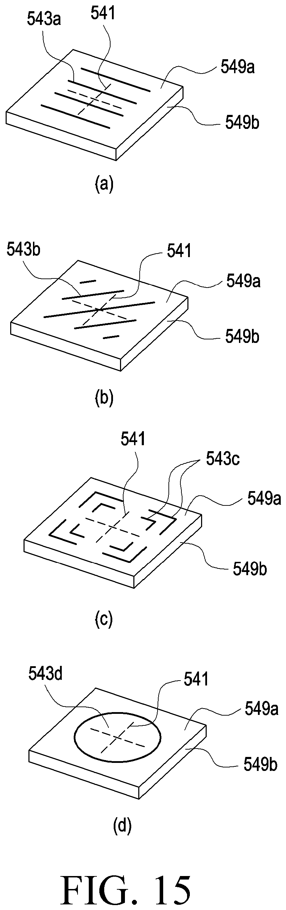

FIG. 15 illustrates exemplary deformation-resistant areas of a sealing member according to various embodiments.

Referring to FIG. 15, the sealing member 540 may include an adhesive layer 549a, a sealing layer 549b, and any of deformation-resistant areas 543a to 543d. The sealing member 540 of FIG. 15 is wholly or partially identical or similar to the sealing member 540 of FIG. 5 or FIG. 14, and thus a redundant description will be avoided.

According to various embodiments, the adhesive layer 549a may form an outer layer of the sealing member 540 and be bonded (e.g., SMT using a solder) to a circuit board (e.g., the first substrate 510 and/or the second substrate 520 of FIG. 4). The sealing layer 549b may be located under the adhesive layer 549a and include an elastic material. According to an embodiment, the adhesive layer 549a and the sealing layer 549b may be formed of materials having different thermal expansion coefficients or the same material.

According to various embodiments, a deformation-resistant area 543 may be formed around an insertion area 541 or an insertion opening 542. For example, the deformation-resistant area 543 may be formed by removing or etching a portion of the adhesive layer 549a in an area adjacent to the insertion area 541 or the insertion opening 542 to prevent deformation of the insertion area 541 and/or the insertion opening 542. As a result, deformation of the sealing member 540 caused by the difference between the thermal expansion coefficients of the adhesive layer 549a and the sealing layer 549b may be reduced in a process of attaching the sealing member 540 to the circuit board module 500.

According to various embodiments, the deformation-resistant area 543a may be formed on the adhesive layer 549a in a horizontal or vertical direction relative to the shape of the sealing member 540. For example, when the sealing member 540 has a square shape, the deformation-resistant area 543a may be formed by etching a portion of the adhesive layer 549a in the horizontal or vertical direction to cover all or a portion of the insertion area 541.

According to various embodiments, the deformation-resistant area 543b may be formed on the adhesive layer 549a in a diagonal direction relative to the shape of the sealing member 540. For example, when the sealing member 540 has a square shape, the deformation-resistant area 543b may be formed by etching a portion of the adhesive layer 549b in the diagonal direction to cover all or a portion of the insertion area 541. Further, the deformation-resistant area 543b may be formed in a center area of the adhesive layer 549a.

According to various embodiments, the deformation-resistant area 543c may be formed to be bend-shaped on the adhesive layer 549a. The bend shape may include a gently curved shape and a sharply curved shape (e.g., L-shaped). According to an embodiment, the deformation-resistant area 543c may be bend-shaped around the insertion area 541 and located on an outer portion of the adhesive layer 549a (e.g., near each vertex of the sealing member 540) in the bend shape, and the insertion area 541 may be formed between a plurality of deformation-resistant areas 543c.

According to various embodiments, the deformation-resistant area 543d may be formed by removing a partial area of the adhesive layer 549a corresponding to the insertion area 541. According to an embodiment, the deformation-resistant area 543d may be formed to include all or a portion of the insertion area 541. For example, the deformation-resistant area 543d may be an opening in which a portion of the adhesive layer 549a and/or the sealing layer 549b is removed to include the insertion area 541. According to an embodiment, the deformation-resistant area 543d may be, but not limited to, a circular area, and may be formed as a square area or various polygonal areas.

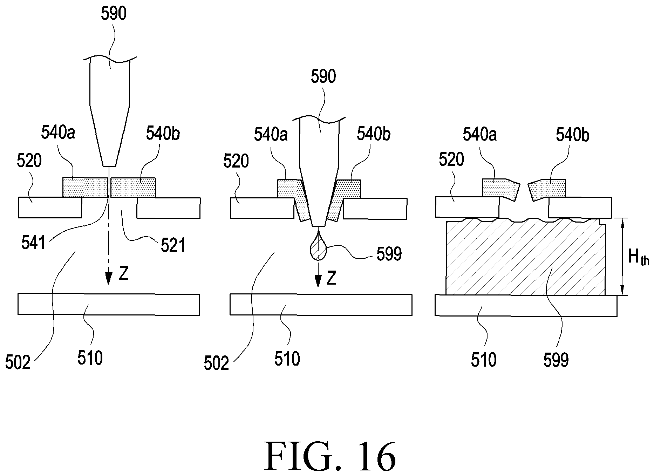

FIG. 16 is a cross-sectional view illustrating a process of injecting a filler through a sealing member according to various embodiments. The circuit board module 500 of FIG. 16 may be wholly or partially identical or similar to the circuit board module 500 of FIG. 5, and the sealing member 540 of FIG. 16 may be wholly or partially identical or similar to the sealing member 540 of FIGS. 14 and 15. Therefore, a redundant description will be avoided.

Referring to FIG. 16, the nozzle 590 may be inserted into the internal space 502 through the sealing member 540.

According to various embodiments, the nozzle 590 may be inserted in a vertical direction (z-axis direction) of the circuit board module 500 through the insertion area 541. According to an embodiment, the nozzle 590 may be inserted into the internal space 502 while pressing a first pressed area 540a and a second pressed area 540b adjacent to the insertion area 541. For example, when the nozzle 590 presses the first pressed area 540a and the second pressed area 540b, the first pressed area 540a and the second pressed area 540b may be deformed in the Z-axis direction, and the insertion area 541 may expand to allow the nozzle 590 to be inserted into the internal space 502. According to an embodiment, the nozzle 590 may apply the filler 599 onto the first substrate 510, while being inserted into the internal space 502.

According to various embodiments, after the nozzle 590 is removed from the insertion area 541, the shape of the sealing member 540 may be restored. In an example, as described above, the insertion area 541 may be formed in the form of a slit such that the first pressed area 540a and the second pressed area 540b may contact each other once pressure applied by the nozzle 590 is released. Accordingly, the sealing member 540 may prevent backflow of the filler 599. According to an embodiment, as the backflow of the filler 599 is prevented, the filler 599 may be located only in the internal space 502, and, for example, the filler 599 may be deposited to or below the predetermined height Hth described above.

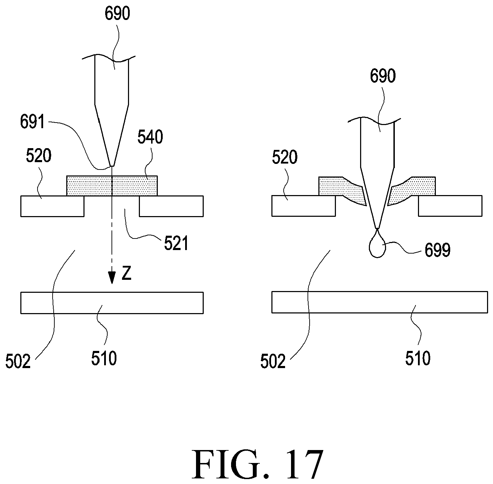

FIG. 17 is a diagram illustrating a nozzle and a process of injecting a filler through the nozzle according to another embodiment.

Referring to FIG. 17, a nozzle 690 may be inserted into the internal space 502, penetrating at least a portion of a sealing member 640. The sealing member 640 according to an embodiment may not separately include an insertion area. The circuit board module 500 of FIG. 17 may be wholly or partially identical or similar to the circuit board module 501 of FIG. 5, and thus a redundant description will be avoided.

According to various embodiments, the nozzle 690 may have a sharply formed end 691. The sharply formed end 691 may penetrate the sealing member 640 and be inserted into the internal space 502. The nozzle 690, which has penetrated the sealing member 640 and has been inserted into the internal space 502, may apply the filler 599.

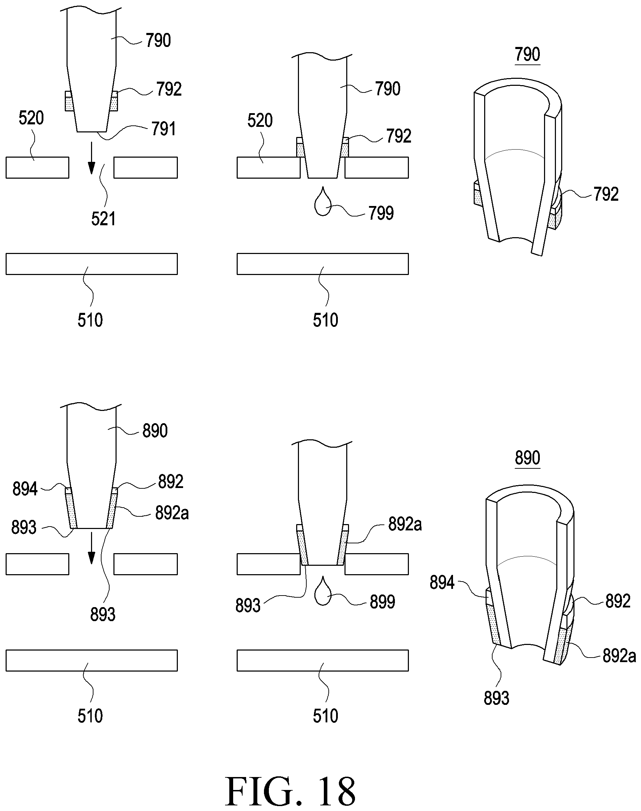

FIG. 18 is a diagram illustrating a nozzle including a sealing member and a process of injecting a filler through the nozzle according to another embodiment.

Referring to FIG. 18, nozzles 790 and 890 may include sealing members 792 and 892. The circuit board module 500 of FIG. 18 may be wholly or partially identical or similar to the circuit board module 500 of FIG. 5, and thus a redundant description will be avoided.

According to various embodiments, although the sealing members 792 and 892 may be included in a portion (e.g., the inlet 521 of the second substrate 520) of the circuit board module as described above, they may also be included in the nozzles 790 and 890. According to an embodiment, the sealing members 792 and 892 may be disposed on one side of the nozzles 790 and 890 (e.g., near inlets of the nozzles). According to an embodiment, the sealing members 792 and 892 disposed on the nozzles 790 and 890 may be combined with the inlet 521 to seal the inlet 521 of fillers 799 and 899.

According to various embodiments, the sealing member 792 may have a tube shape. For example, the sealing member 792 may be formed to surround a portion of the nozzle 790 in the horizontal direction. According to an embodiment, the sealing member 792 may be disposed near an end 791 of the nozzle 790. For example, the sealing member 792 may be disposed above the end 791 of the nozzle 790, such that the end 791 is insertable into the internal space 502. According to an embodiment, the width of the sealing member 792 may be formed to be larger than the width of the inlet 521 in order to seal the inlet 521.

According to various embodiments, the sealing member 892 may have a tapered shape. For example, the sealing member 892 may have a shape that gradually narrows from a top end 894 toward a bottom end 893. Further, the sealing member 892 may have a shape corresponding to the shape of the nozzle 890. According to an embodiment, the bottom end 893 of the sealing member 892 may be formed to have a width less than the width of the inlet 521 to allow at least a portion of the nozzle 890 to be inserted into the inlet 521. According to an embodiment, the top end 894 of the sealing member 892 may be formed to have a width larger than the width of the inlet 521. For example, the top end 894 of the sealing member 892 may be formed to have a width larger than the width of the inlet 521 to prevent further insertion of the nozzle 890. According to an embodiment, the tapered shape of the sealing member 892 may allow a side surface 892a to be in close contact with the inlet 521 and prevent backflow of the filler 899 during injection of the filler 899 from the nozzle 890. For example, the sealing member 892 may seal the inlet 521 by a force pressing vertically on the nozzle 890.

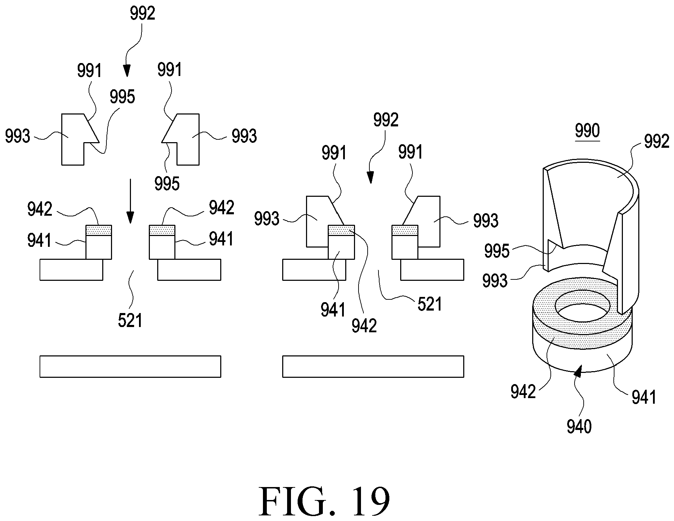

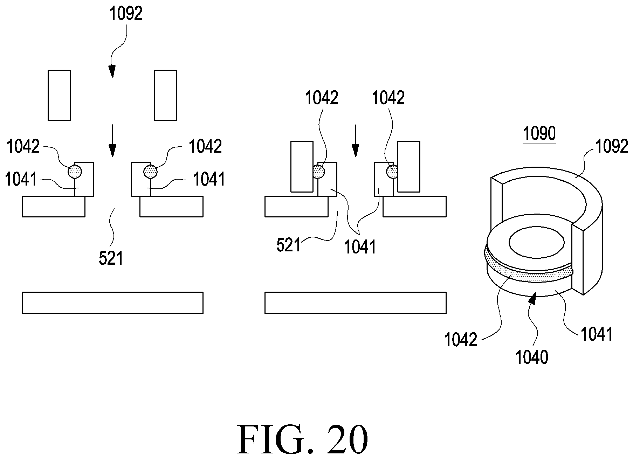

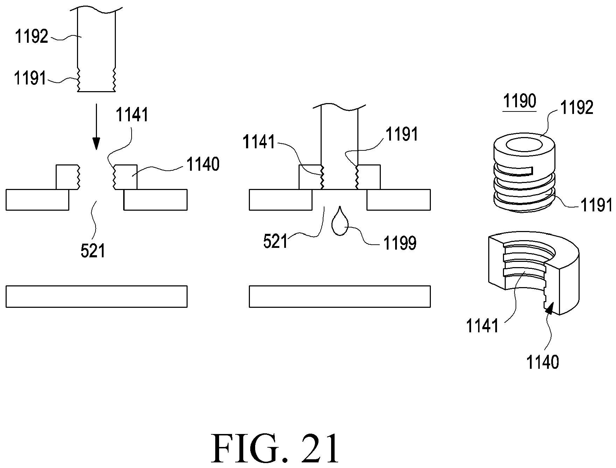

FIG. 19 is a diagram illustrating a backflow prevention structure according to various embodiments. FIG. 20 is a diagram illustrating a backflow prevention structure according to another embodiment. FIG. 21 is a diagram illustrating a backflow prevention structure according to another embodiment.

Referring to FIGS. 19 to 21, backflow prevention structures may be provided by combining sealing portions 992, 1092, and 1192 included in nozzles 990, 1090, and 1190 with sealing members 940, 1040, and 1140 disposed on the second substrate 520.

According to various embodiments, the sealing portions 992, 1092, and 1192 and the sealing members 940, 1040, and 1140 may be fastened with each other. For example, the sealing portions 992, 1092, and 1192 and the sealing members 940, 1040, and 1140 may contact and be engaged with each other to prevent backflow of fillers 999, 1099, and 1199 injected from the nozzles 990, 1090, and 1190.

According to various embodiments, the sealing portion 992 may be provided in the form of a nut, and the sealing member 940 may be provided in the form of a bolt. According to an embodiment, the sealing portion 990 may include a tapered injection portion 991, a first contact area 995 located under the injection portion 991 to contact the sealing member 940, and a peripheral area 993 to surround the sealing member 940. According to an embodiment, the sealing member 940 may include a base portion 941 disposed near the inlet 521 and a second contact area 942 disposed on the base portion 941. According to an embodiment, the base portion 941 may be formed of a metal material, and the second contact area 942 may be formed of a rubber material. For example, during injection of the filler, the nozzle 990 may press the sealing member 940 in the vertical direction, and the first contact area 995 may compress the second contact area 942 formed of rubber, thereby sealing the inlet 521. According to an embodiment, the first contact area 995 and the second contact area 942 may have shapes corresponding to each other and be formed to be flat. As the first contact area 995 and the second contact area 942 are formed to be flat, a contact area and sealing efficiency may be increased. According to an embodiment, the second contact area 942 may be formed to have an outer diameter larger than an inner diameter of the peripheral area 993. Therefore, a coupling force between the second contact area 942 and the peripheral area 993 may be increased, and the sealing efficiency may be improved.

According to various embodiments, the sealing portion 1092 may be provided in the shape of a cylinder, and the sealing member may be provided in the shape of a ring. According to an embodiment, a distal end of the nozzle 1090 may be provided as a cylindrical sealing portion 1092. According to an embodiment, the sealing member 1040 may include a base portion 1041 disposed near the inlet 521 and a sealing area 1042 disposed to surround all or a portion of the base portion 1041. For example, the base portion 1041 may be formed of a metal material, and the sealing area 1042 may be formed of a rubber material. According to an embodiment, the sealing area 1042 may be formed to have an outer diameter larger than an inner diameter of the sealing portion 1092. In addition, the description of the sealing portion 1092 and the sealing member 1040 may be adapted from the description of the sealing portion 992 and the sealing member 940 of FIG. 19.

According to various embodiments, the sealing portion 1192 may be provided in the form of a male thread, and the sealing member 1140 may be provided in the form of a female thread. According to an embodiment, the sealing portion 1192 may include a first threaded area 1191, and the sealing member 1140 may include a second threaded area 1141. For example, the sealing portion 1192 and the sealing member 1140 may be screwed together so that the filler may be injected into the internal space of the circuit board module, while the nozzle 1190 and the sealing member 1140 are shielded from each other. However, this is exemplary, and it will be understood that that the nozzle 1190 may be provided in the form of a female thread, and the sealing member 1140 may be provided in the form of a male thread.

According to various embodiments of the disclosure, the circuit board module may be formed by stacking three or more substrates. In the following description, a backflow prevention structure when three or more substrates are stacked according to various embodiments will be described with reference to the drawings.

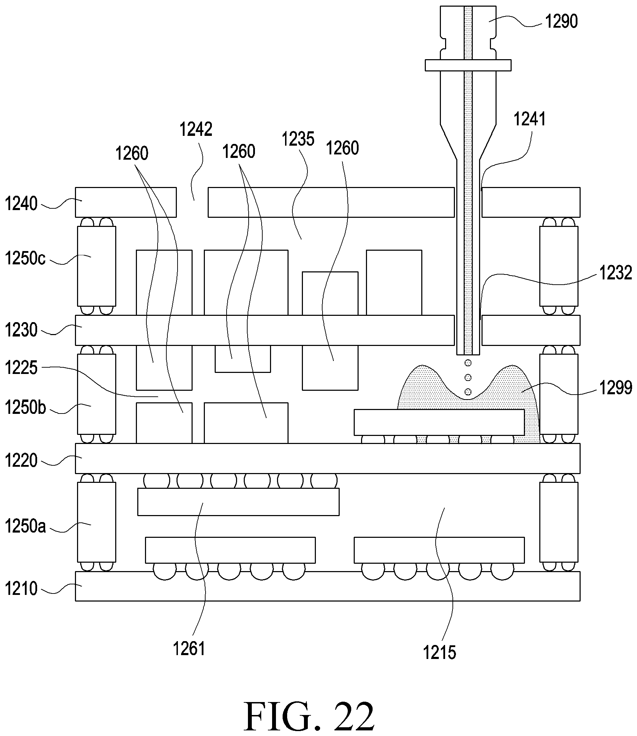

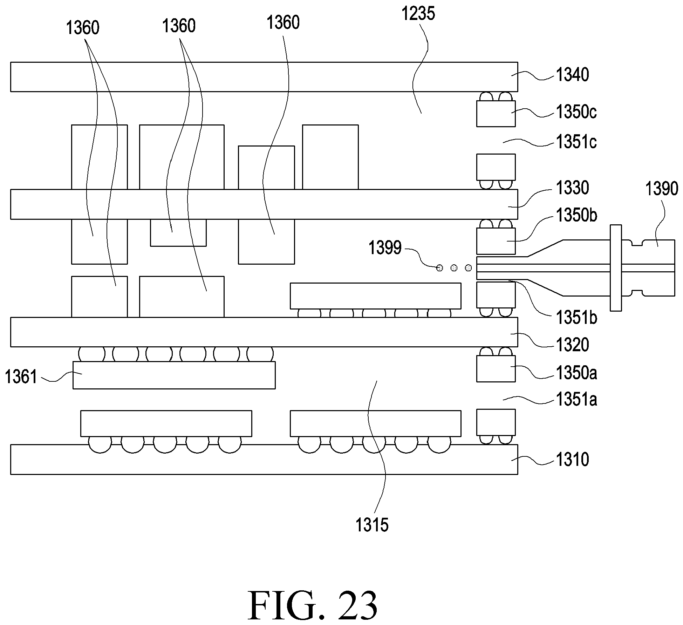

FIG. 22 illustrates a first exemplary multi-layer stacked circuit board module according to various embodiments. FIG. 23 illustrates a second exemplary multi-layer stacked circuit board module according to various embodiments.

Referring to FIGS. 22 and 23, a circuit board module 1200 may include a first substrate 1210, a second substrate 1220, a third substrate 1230, and a fourth substrate 1240, and may be formed by stacking them sequentially. In addition, a plurality of interposers 1250a, 1250b, and 1250c may be disposed among the substrates to connect the substrates and provide internal spaces 1215, 1225, and 1235 among the substrates.

According to various embodiments, inlets 1241 and 1232 may be formed on all or some of the substrates 1210, 1220, 1230, and 1240 forming the circuit board module 1200. For example, the inlets 1241 and 1232 may be formed on both the fourth substrate 1240 and the third substrate 1230, and the positions of the inlets 1241 and 1232 may correspond to each other. According to an embodiment, a nozzle 1290 may penetrate both the first inlet 1241 and the second inlet 1232 and apply a filler 1299 to the internal space 1222 between the second substrate 1220 and the third substrate 1230. According to an embodiment, the fourth substrate 1240 may include a third inlet 1242. The third inlet 1242 may function as an inlet for insertion of the nozzle 1290 and/or an opening for directing an air flow within the circuit board module 1200 (e.g., the first opening 522a and the second opening 522b of FIG. 5).

According to various embodiments, all or some of a plurality of interposers 1350a, 1350b, and 1350c may include inlets 1351a, 1351b, and 1351c. The configuration of a circuit board module 1300 according to an embodiment may be wholly or partially identical or similar to the configuration of the circuit board module 1200 described above, and thus a redundant description will be avoided.

According to various embodiments, a nozzle 1390 may be inserted into a first inlet 1351a, a second inlet 1351b, and/or a third inlet 1351c and inject a filler into an internal space of the circuit board module 1300.

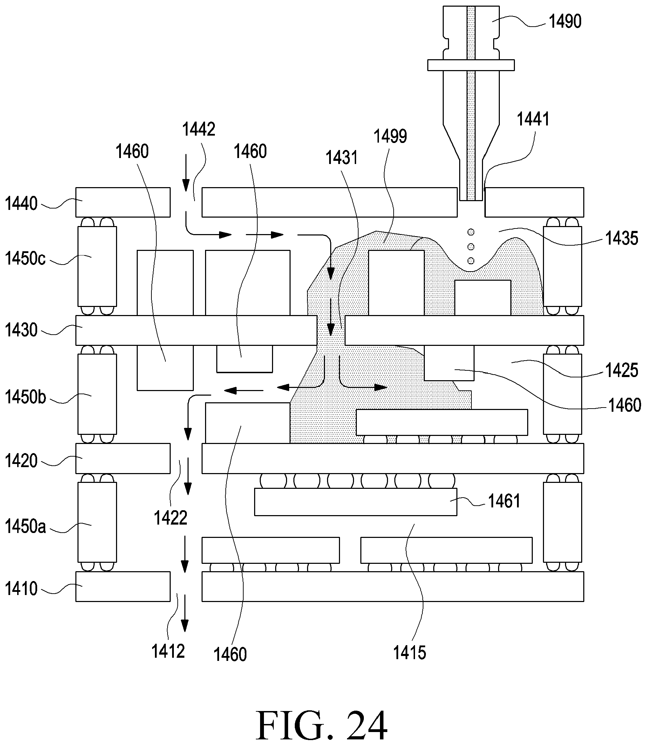

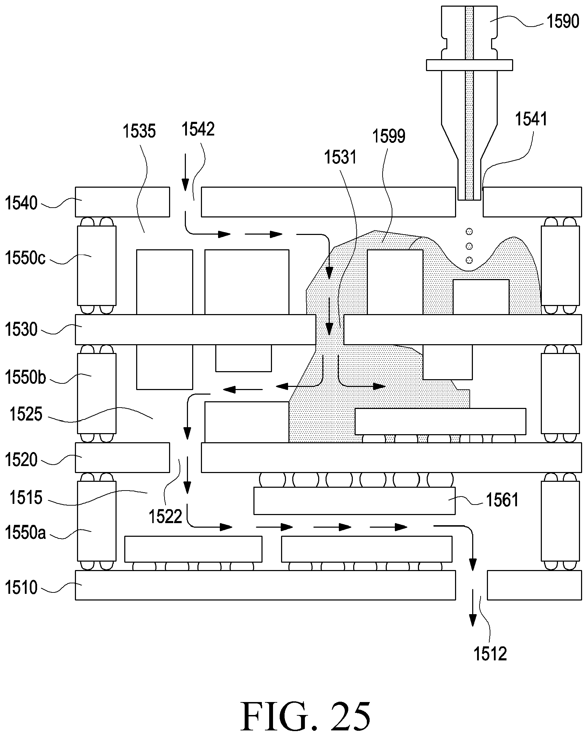

FIG. 24 is a diagram illustrating a third exemplary multi-layer stacked circuit board module and injection of a filler thereinto according to various embodiments. FIG. 25 is a diagram illustrating a fourth exemplary multi-layer stacked circuit board module and injection of a filler thereinto according to various embodiments.

Referring to FIGS. 24 and 25, a circuit board module 1400 may include inlets 1441 and 1541, first openings 1442 and 1542, and second openings 1412 and 1512. The configuration of the circuit board module 1400 of FIG. 23 may be wholly or partially identical or similar to the configuration of the circuit board module 1200 of FIGS. 22 and/or 23, and thus a redundant description will be avoided.

According to various embodiments, an air flow for application of a filler 1499 may be directed within the circuit board module 1400 in which three or more substrates are stacked. For example, with the filler 1499 injected into a first internal space 1435 of the circuit board module 1400, an air flow may be directed within the circuit board module 1400 to apply the filler 1499 to all or some of the first internal space 1435, a second internal space 1425, and/or a third internal space 1415. According to an embodiment, the first opening 1442 formed on a fourth substrate 1400 and the second opening 1412 formed on a first substrate 1410 may direct an air flow in the internal spaces of the circuit board module 1400. For example, with the filler 1499 injected into the third internal space 1435, air may flow into the first opening 1442 and exit from the second opening 1412, and depending on the flow, the filler 1499 may be applied within the internal spaces 1415, 1425, and 1435 in response to the air flow. According to an embodiment, third opening(s) 1422 and 1432 may be formed on the second substrate 1420 and/or the third substrate 1430 to provide an air path and/or a path of the filler 1499 between the first opening 1442 and the second opening 1412.

According to an embodiment, the first opening 1442, the second opening 1412, and/or the third opening 1422 may be disposed at positions for determining the direction of an air flow within the circuit board module 1400. For example, the third opening 1412 may be located opposite to the inlet 1441 with respect to the horizontal direction to further direct a horizontal flow of air in the internal spaces 1415, 1425, and 1435. In another example, the third opening 1512 may be located on the same side as the inlet 1441 with respect the horizontal direction to further direct a vertical flow of air in the internal spaces 1415, 1425, and 1435.

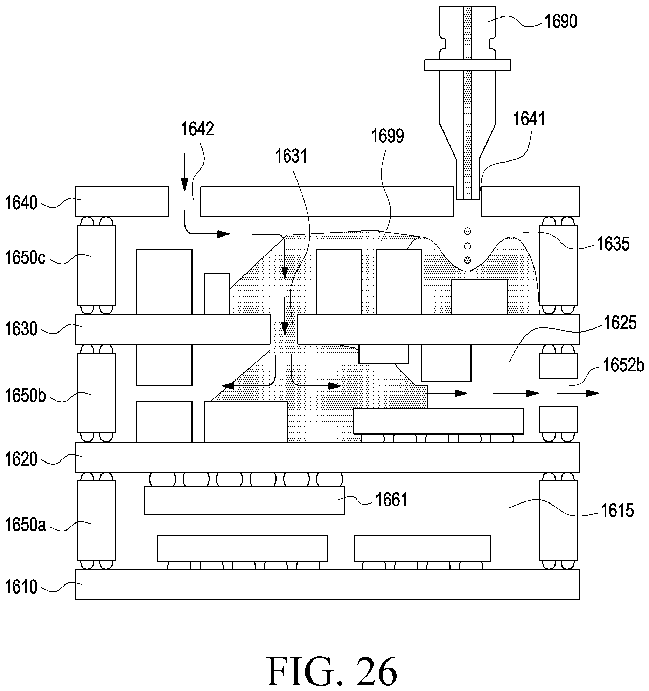

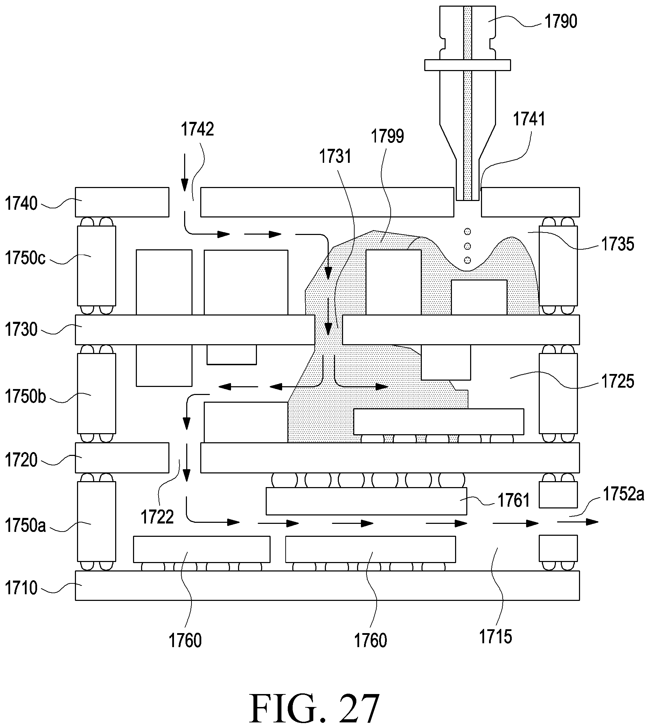

FIG. 26 is a diagram illustrating a fifth exemplary multi-layer stacked circuit board module and injection of a filler thereinto according to various embodiments. FIG. 27 is a diagram illustrating a sixth exemplary multi-layer stacked circuit board module and injection of a filler thereinto according to various embodiments.

Referring to FIGS. 26 and 27, a circuit board module 1600 may include a first opening 1642 and second openings 1652b and 1652a formed to face different directions. The circuit board module 1600 of FIG. 24 may be wholly or partially identical or similar to the circuit board module 1400 of FIG. 24, and thus a redundant description will be avoided.

According to various embodiments, the first opening 1642 may be formed on a fourth substrate 1640 and the second openings 1652b and 1652c may be formed on interposers 1650b and 1650c. According to an embodiment, air introduced from the first opening 1642 formed on the fourth substrate 1640 may exit through the second openings 1652b and 1652c, thereby directing an air flow within the circuit board module 1600. As described above, third openings 1622 and 1632 may be formed on a second substrate 1620 and/or a third substrate 1630. Likewise, as an air flow is directed within the circuit board module 1600, the direction of application of a filler 1699 may change as described above, and thus a redundant description will be avoided.

According to various embodiments, the second opening(s) 1652b and 1652c may be formed in some or all of a first interposer 1650c and/or a second interposer 1650b. Positions at which the second openings 1652b and 1652c are formed may be determined according to an area to which the filler 1699 is to be applied or the positions of components 1660 disposed on the circuit board module 1600. For example, the second openings 1652b and 1652c may be disposed to provide an air flow path for application of the filler 1699 to an area corresponding to a heat source 1661.

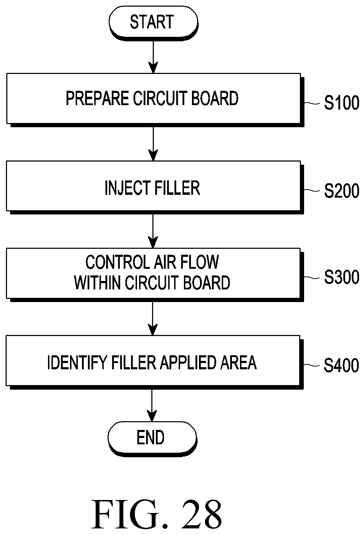

FIG. 28 is a flowchart illustrating a method of injecting a filler into a circuit board module to manufacture a circuit board module to which a filler is applied according to various embodiments.

Referring to FIG. 25, the method of injecting a filler into a circuit board module may include preparing a circuit board module provided with a backflow prevention structure (S100), injecting a filler through an inlet (S200), and controlling an air flow within the circuit board module through a first opening and a second opening (S300).

The method of manufacturing a circuit board module according to various embodiments may be implemented by an automated circuit board module manufacturing system. Further, the circuit board module manufacturing system may include the nozzles 590, 690, 790, 890, 990, 1090, 1190, 1290, 1490, and 1690 according to the various embodiments described above.

In step S100 of preparing a circuit board module, the circuit board module may include the circuit board modules 500, 1200, 1400, and 1600 according to various embodiments described above, which may include the sealing members 540, 640, 1040, and 1140 according to various embodiments described above.

In step S200 of injecting a filler, the manufacturing system may inject the filler into the circuit board through the inlet 521 of the circuit board module. According to an embodiment, the circuit board module may include a sealing member according to various embodiments described above, and the nozzle may penetrate the sealing member to inject the filler into the circuit board module. According to an embodiment, the manufacturing system may inject the filler for a predetermined time. Alternatively, the manufacturing system according to an embodiment may determine a filler injection time based on a result of identifying a filler applied area (S400). For example, the manufacturing system may determine a filler injection end time based on the result of identifying the filler applied area (S400) (e.g., the filler 599 is applied to the area corresponding to the inspection hole 529, see FIGS. 9 to 12).

In step S300 of controlling an air flow within the circuit board module, the manufacturing system may introduce or exhaust air through first and second openings included in the circuit board module according to various embodiments described above. For example, the manufacturing system may introduce air through the first opening and exhaust air through the second opening to direct the air flow within the circuit board module. According to an embodiment, the manufacturing system may introduce and/or exhaust air for a predetermined time. In an example, the duration of a time period during which air is introduced and/or sucked in may be set to be longer than the duration of a time period during which the filler is injected. In addition, according to an embodiment, the manufacturing system may determine a time period during which air is introduced based on the result of identifying the filler applied area (S400). For example, the manufacturing system may determine an end time of air introduction based on the result of identifying the filler applied area (S400) (e.g., the filler 599 is applied to the area corresponding to the inspection hole 529, see FIGS. 9 to 12).

According to an embodiment, the manufacturing system may perform step S200 of injecting the filler and step S300 of controlling an air flow simultaneously or sequentially.

According to an embodiment, the manufacturing system may control the air flow within the circuit board module such that step S200 of injecting the filler is performed longer than step S300 of controlling the air flow. According to various embodiments, it may take a specific time to cure the filler after the injection of the filler from the nozzle, and the manufacturing system may control the air flow within the circuit board module until the injected filler is cured, thereby controlling the application area of the filler.

According to an embodiment, the manufacturing system may determine, through the inspection hole 529 (see FIGS. 7 to 10), whether the filler has been applied over a required area, as described above. Further, the manufacturing system may be configured to repeat or end step S200 of injecting the filler and/or step S300 of introducing air. According to an embodiment, in the case where the filler injection step S200 and/or the air introduction step S300 are performed for a predetermined time, when determining that the filler has not reached the area corresponding to the inspection hole 529, the manufacturing system may repeat the filler injection step S200 and/or the air introduction step S300. According to an embodiment, the manufacturing system may terminate the filler injection step S200 and/or the air introduction step S300, when determining that the filler has been applied to the area corresponding to the inspection hole 529.

According to various embodiments, a circuit board module may be provided, including: a first substrate; a second substrate including a first opening and disposed above the first substrate; a first interposer disposed between the first substrate and the second substrate to electrically connect the first substrate and the second substrate, and providing a first space between the first substrate and the second substrate; a sealing member attached to cover the first opening; and a filler disposed between the first substrate and the second substrate. The sealing member may include an insertion area allowing a nozzle for injecting the filler to be inserted into the first opening, and a second opening allowing air to be introduced into the first space therethrough and a third opening allowing air to be exhausted from the first space therethrough may be formed on at least one of the first substrate, the second substrate, or the first interposer.

According to various embodiments, the second opening and the third opening may be formed on the second substrate.

According to various embodiments, the second opening may be formed on the second substrate, and the third opening may be formed on the first interposer.

According to various embodiments, the filler may be disposed under the first opening.

According to various embodiments, the second opening may be formed on a first side of the second substrate, and the third opening may be formed on a second side opposite to the first side.

According to various embodiments, a distance between the first opening and the second opening or a distance between the first opening and the third opening may be larger than a distance between the second opening and the third opening.

According to various embodiments, a distance between the first opening and the second opening or a distance between the first opening and the third opening may be set to be equal to or larger than a threshold distance, and the threshold distance may be determined in consideration of at least one of an injection rate or an injection time of the filler.

According to various embodiments, the insertion area may be expanded when pressure is applied, and may be restored and substantially seal the first opening when the pressure is removed.

According to various embodiments, the insertion area may be cross-shaped.

According to various embodiments, the sealing member may include a deformation-resistant area on a top surface thereof to prevent deformation of the sealing area, and the deformation-resistant area may overlap the insertion area or be disposed adjacent to the insertion area.

According to various embodiments, the sealing member may be combined with the nozzle and prevent backflow of the filler.

According to various embodiments, the circuit board module may further include: a third substrate disposed above the second substrate; and a second interposer connecting the second substrate and the third substrate and providing a second space between the second substrate and the third substrate. The first opening may be formed on the third substrate, and the second opening and the third opening may be formed on at least one of the third substrate, the first substrate, the first interposer, or the second interposer.

According to various embodiments, the second substrate may include a fourth opening allowing the filler to be introduced from the second space into the first space or allowing air to be introduced from the second opening into the first space.

According to various embodiments, the circuit board module may include a heat source disposed on the first substrate or the second substrate, and the filler may be applied to an area corresponding to a position where the heating source is disposed.

According to various embodiments, the sealing member may be formed of a rubber material, and the rubber material may include conductivity or non-conductivity.

According to various embodiments, the filler may be formed in a liquid or semi-solid state. According to various embodiments, a method of injecting a filler may include: preparing a circuit board module, wherein the circuit board module includes: a first substrate; a second substrate including a first opening and disposed above the first substrate; an interposer disposed between the first substrate and the second substrate to connect the first substrate and the second substrate and providing a first space between the first substrate and the second substrate; and a sealing member attached to cover the first opening, and wherein a second opening allowing air to be introduced into the first space therethrough and a third opening allowing air to be exhausted from the first space therethrough are formed on at least one of the first substrate, the second substrate, or the first interposer; injecting the filler through the first opening; and injecting air through the second opening.

According to various embodiments, the injection of air through the second opening may end after the injection of the filler.

According to various embodiments, the circuit board module may further include a sealing member including a nozzle insertion area and disposed on the first opening, and the method may further include inserting the nozzle into the nozzle insertion area by pressing the nozzle.

According to various embodiments, the second opening and the third opening may be formed on the second substrate.

The circuit board module and the electronic device including the same according to various embodiments of the disclosure described above are not limited by the foregoing embodiments and drawings, and it will be apparent to those skilled in the art that various substitutions, modifications, and changes can be made within the technical scope of the disclosure.

## Claims

1. A circuit board module inside an electronic device, comprising:
a first substrate;
a second substrate including a first opening and disposed above the first substrate;
a first interposer disposed between the first substrate and the second substrate to electrically connect the first substrate and the second substrate, and providing a first space between the first substrate and the second substrate;
a sealing member attached to cover the first opening; and
a filler disposed between the first substrate and the second substrate,
wherein the sealing member includes an insertion area configured to allow a nozzle for injecting the filler to be inserted into the first opening, and
wherein a second opening configured to allow air to be introduced into the first space therethrough and a third opening configured to allow air to be exhausted from the first space therethrough are formed on at least one of the first substrate, the second substrate, or the first interposer.

2. The circuit board module of claim 1, wherein the second opening and the third opening are formed on the second substrate.

3. The circuit board module of claim 1, wherein the second opening is formed on the second substrate, and the third opening is formed on the first interposer.

4. The circuit board module of claim 1, wherein the filler is disposed under the first opening.

5. The circuit board module of claim 2, wherein the second opening is formed on a first side of the second substrate, and the third opening is formed on a second side opposite to the first side.

6. The circuit board module of claim 1, wherein a distance between the first opening and the second opening or a distance between the first opening and the third opening is less than a distance between the second opening and the third opening.

7. The circuit board module of claim 1, wherein a distance between the first opening and the second opening or a distance between the first opening and the third opening is set to be equal to or larger than a threshold distance, and
wherein the threshold distance is determined in consideration of at least one of an injection rate or an injection time of the filler.

8. The circuit board module of claim 1, wherein the insertion area is configured to be expanded when pressure is applied, and configured to be restored and substantially seal the first opening when the pressure is removed.

9. The circuit board module of claim 8, wherein the insertion area is cross-shaped.

10. The circuit board module of claim 8, wherein the sealing member includes a deformation-resistant area on a top surface thereof to prevent deformation of the sealing area, and
wherein the deformation-resistant area overlaps the insertion area or is disposed adjacent to the insertion area.

11. The circuit board module of claim 1, wherein the sealing member is configured to prevent backflow of the filler, with the nozzle.

12. The circuit board module of claim 1, further comprising:
a third substrate disposed above the second substrate; and
a second interposer connecting the second substrate and the third substrate and providing a second space between the second substrate and the third substrate,
wherein the first opening is formed on the third substrate, and
wherein the second opening and the third opening are formed on at least one of the third substrate, the first substrate, the first interposer, or the second interposer.

13. The circuit board module of claim 12, wherein the second substrate includes a fourth opening configured to allow the filler to be introduced from the second space into the first space or allow air to be introduced from the second opening into the first space.

14. The circuit board module of claim 1, comprising a heat source disposed on the first substrate or the second substrate,
wherein the filler is applied to an area corresponding to a position where the heating source is disposed.

15. The circuit board module of claim 1, wherein the sealing member is formed of a rubber material, and
wherein the rubber material includes conductive material or non-conductive material.
